(19)

Europäisches
Patentamt
European
Patent Office
Office européen
des brevets

(11) **EP 4 053 910 A1**

(12) **EUROPEAN PATENT APPLICATION**

(43) Date of publication:
**07.09.2022 Bulletin 2022/36**

(51) International Patent Classification (IPC):
*H01L 29/06* (2006.01)   *H01L 29/808* (2006.01)
*H01L 29/10* (2006.01)   *H01L 29/417* (2006.01)

(21) Application number: **21160037.4**

(22) Date of filing: **01.03.2021**

(52) Cooperative Patent Classification (CPC):
**H01L 29/0634; H01L 29/0615; H01L 29/1066;**
**H01L 29/41766; H01L 29/808**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Infineon Technologies Dresden GmbH**
**& Co . KG**
**01099 Dresden (DE)**

(72) Inventors:
• **MAHMOUD, Ahmed**
  **81539 München (DE)**
• **HIRLER, Franz**
  **84424 Isen (DE)**
• **WEIS, Rolf**
  **01109 Dresden (DE)**

(74) Representative: **Westphal, Mussgnug & Partner,**
**Patentanwälte mbB**
**Werinherstraße 79**
**81541 München (DE)**

(54) **METHOD OF PRODUCING A TRANSISTOR DEVICE**

(57)     Disclosed is a method. The method includes: forming a layer stack (100) with a plurality of semiconductor layers (10*, 11*, 12*) each comprising at least one of a first implanted region (11*) comprising implanted dopant atoms of a first doping type and a second implanted region (12*) comprising implanted dopant atoms of a second doping type and each having a thickness specific dopant dose (TD), which is given by a dopant dose (D) of the respective semiconductor layer (10*) multiplied with a thickness (h) of the respective semiconductor layer (10*); and annealing the layer stack (100) to activate the implanted dopant atoms. Forming the layer stack (100) includes forming the plurality of semiconductor layers (10*) such that first implanted regions (11*) and second implanted regions (12*) are arranged alternatingly in the layer stack (100), and such that in the layer stack (100) the thickness specific dopant dose (TD) increases towards a lower vertical end (z1) of the layer stack (100).

FIG 6

EP 4 053 910 A1

**Description**

This disclosure in general relates to a method of producing a transistor device, in particular a lateral superjunction transistor device.

A lateral superjunction transistor device usually includes a layer stack with a plurality of first semiconductor layers of a first doping type and a plurality of second semiconductor layers of a second doping type complementary to the first doping type. Further, the transistor device includes a source region and a drain region that are spaced apart from each other in a lateral direction of the layer stack and each adjoin the plurality of first semiconductor layers, and a gate that is configured to control an operating state of the transistor device. When the gate controls the transistor device to be in an on-state the first semiconductor layers form conducting channels between the source region and the drain region, and when the gate controls the transistor device to be in an off-state depletion regions expand in the first and second semiconductor layers so that conducting channels between the source region and the drain region are interrupted.

A lateral superjunction transistor may be formed by epitaxially growing a plurality of semiconductor layers one above the other, alternatingly implanting dopant atoms of the first doping type and dopant atoms of the second doping type into the semiconductor layers, and diffusing and electrically activating the implanted dopant atoms in a temperature process after forming the semiconductor layers.

An on-resistance of the transistor device is an electrical resistance between the source region and the drain region in the on-state. Basically, the more first and second semiconductor layers the transistor device includes the lower the on-resistance. One could assume that the on-resistance decrease linearly when the number of first and second semiconductor layers increases (and the first and second layers have the same thickness and the same dopant dose). Simulations and experiments, however, have revealed that the relative contribution of each additional first semiconductor layer to the reduction of the on-resistance decreases as the number of first and second semiconductor layers increases.

There is a need for an improved lateral semiconductor device.

One example relates to a method. The method includes forming a layer stack with a plurality of semiconductor layers each having implanted dopant atoms of a first doping type or a second doping type implanted therein and each having a thickness specific dopant dose, which is given by a dopant dose of the respective semiconductor layer multiplied with a thickness of the respective semiconductor layer, and annealing the layer stack to activate the implanted dopant atoms. Forming the layer stack includes forming the plurality of semiconductor layers such that semiconductor layers including implanted dopant atoms of the first doping type and semiconductor layers including dopant atoms of the second doping type are arranged alternatingly in the layer stack, and such that in the layer stack the thickness specific dopant dose increases towards a lower vertical end of the layer stack.

Examples are explained below with reference to the drawings. The drawings serve to illustrate certain principles, so that only aspects necessary for understanding these principles are illustrated. The drawings are not to scale. In the drawings the same reference characters denote like features.

Figure 1 schematically illustrates one example of a semiconductor body with a plurality of first semiconductor layers of a first doping type and a plurality of second semiconductor layers of a second doping type;

Figure 2 illustrate process steps of one example of a method for forming a semiconductor body stack of the type shown in Figure 1;

Figures 3A - 3F schematically illustrate a semiconductor body of the type shown in Figure 1 during different process steps of a multi-epi-multi-implant-(MEMI)-method;

Figures 4A - 4C illustrate a first example of a method for forming a first and a second implanted region;

Figures 5A and 5B illustrate a second example of a method for forming a first and a second implanted region;

Figure 6 illustrates a doping profile of a layer stack formed in accordance with a conventional MEMI method;

Figure 7 schematically illustrates a thickness specific dopant dose (TSDD) profile of a layer stack formed in accordance with an improved (graded) MEMI method;

Figure 8 schematically illustrates one example of a thickness profile and a dopant dose profile that result in thickness specific dopant dose profile of the type shown in Figure 7;

Figure 9 illustrates a doping profile of a layer stack having a thickness profile and a dopant dose profile of the type shown in Figure 7;

Figure 10 schematically illustrates another example of a thickness profile and a dopant dose profile that result in thickness specific dopant dose profile of the type shown in Figure 7;

Figure 11 illustrates a doping profile of a layer stack having a thickness profile and a dopant dose profile of the type shown in Figure 8;

Figure 12 illustrates a further examples of a TSDD profile;

Figures 13 - 14 illustrate examples of thickness and dopant dose profiles corresponding to the TSDD profile according to Figure 12;

Figure 15 illustrates a TSDD profile and corresponding thickness and dopant dose profiles according to another example;

Figures 16A - 16B schematically illustrate one example of a transistor device that has been formed based on a layer stack of the type shown in Figure 1;

Figures 17A - 17C illustrate the on-resistances of transistor devices that have been implemented based on a conventional layer stack (Figure 17A), a layer stack with a graded dopant dose (Figure 17B), and a layer stack with a graded thickness (Figure 17B); and

Figure 18 illustrates the on-resistance of a transistor device that has been implemented based on a layer stack formed in a "cold" epitaxial growth process.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

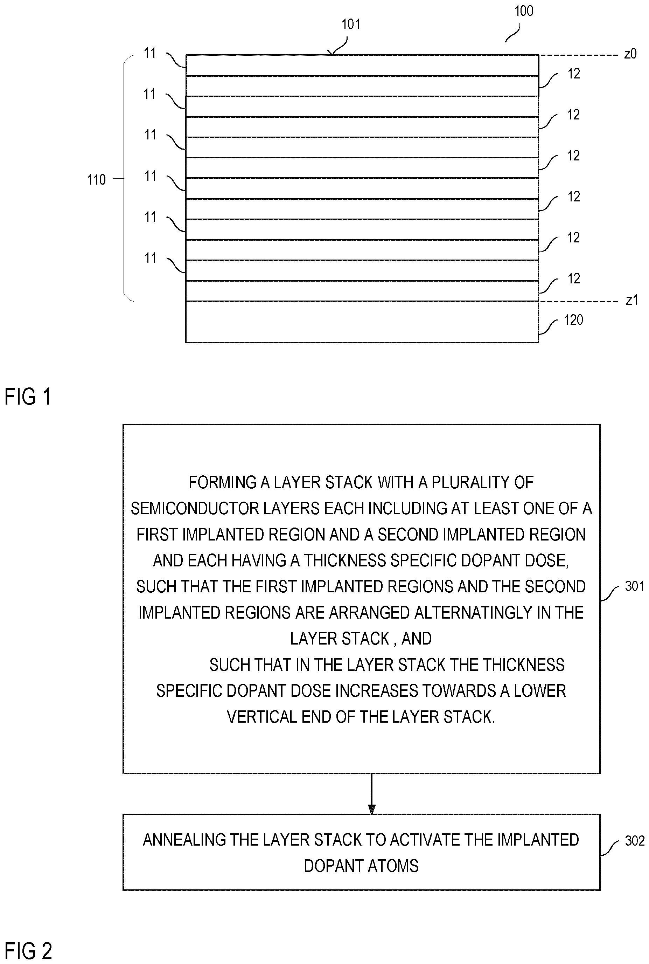

Figure 1 schematically illustrates one example of a semiconductor body 100 which may form the basis of a lateral superjunction semiconductor device. Referring to Figure 1, the semiconductor body 100 includes a plurality of first semiconductor regions 11 and a plurality of second semiconductor regions 12. The first semiconductor regions 11 and the second semiconductor regions 12 are arranged alternatingly in a vertical direction z of the semiconductor body 100. The "vertical direction" is the direction in which the first and second semiconductor regions 11, 12 are arranged one above the other and is perpendicular to a first surface 101, which may also be referred to as upper surface, of the semiconductor body 100.

The semiconductor body 100 includes a layer stack 110 with a plurality of semiconductor layers formed one above the other. According to one example, each of these layers includes one first semiconductor region 11 or one second semiconductor region 12. According to another example, each of these layers includes one first semiconductor region 11 and one second semiconductor region 12. This is explained in detail herein further below. The first surface 101 is formed by an uppermost one of the semiconductor layers of the layer stack 110.

The semiconductor body 100 may further include a carrier 120 on top of which the layer stack 110 with the first and second semiconductor regions 11, 12 is formed. carrier 120According to one example, the carrier 120 includes a monocrystalline semiconductor substrate. The carrier 120 and the layer stack 110 with the first and second semiconductor regions 11, 12 may include a conventional semiconductor material such as, for example silicon (Si) or silicon carbide (SiC).

Referring to Figure 1, the layer stack 110 has an upper vertical end at the first surface 101 and a lower vertical end at an interface between the layer stack 110 and the carrier 120. In Figure 1, z0 denotes the vertical position of the upper vertical end and z1 denotes the vertical position of the lower vertical end of the layer stack 110.

The first semiconductor regions 11 are doped semiconductor regions of a first doping type, which means that the first semiconductor regions 11 have an effective doping concentration of the first doping type. The second semiconductor regions 12 are doped semiconductor regions of a second doping type complementary to the first doping type, which means that the second semiconductor regions 11 have an effective doping concentration of the first doping type. The first doping type is an n-type or a type. Consequently, the second doping type is a p-type or an n-type.

The effective doping concentration N at each position (in each region) of the semiconductor body 100 is, for example, given by

$$N = Nn - Np \qquad (1),$$

wherein Nn denotes the concentration of n-type dopant atoms and Np denotes the concentration of p-type dopant atoms at the respective position (in the respective region). The n-type dopant atoms may include Phosphorous (P) and/or Arsenic (As) atoms, and the p-type dopant atoms may include Boron (B) atoms, for example. Referring to equation (1), the effective doping concentration is (i) positive when the n-type dopant atoms prevail, (ii) negative when the p-type dopant atoms prevail, and (iii) zero when n-type and p-type dopant atoms are balanced.

Figure 2 illustrates a flowchart that illustrates one example of a method for forming a layer stack 110 with first and second semiconductor regions of the type shown in Figure 1. Referring to process sequence 301, this method includes forming a layer stack with a plurality of semiconductor layers, wherein each of these semiconductor layers includes at least one of a first implanted region and a second implanted region, wherein the first implanted region includes implanted dopant atoms of the first doping type and the second implanted region includes implanted dopant atoms of the second doping type. The layer stack is formed such that the first implanted regions and the second implanted regions are arranged alternatingly in the layer stack. Furthermore, the layer stack is formed such that in the layer stack the thickness specific dopant dose increases towards a lower vertical end of the layer stack. The thickness specific dopant dose TSD of each implanted layer is given by a thickness h of the respective layer multiplied with the dopant dose D implanted into the respective layer,

$$Td = D \cdot h \quad (2).$$

The thickness h is the vertical dimension of the respective layer.

Referring to process sequence 302, the method further includes annealing the layer stack with the first and second implanted regions to activate the implanted dopant atoms.

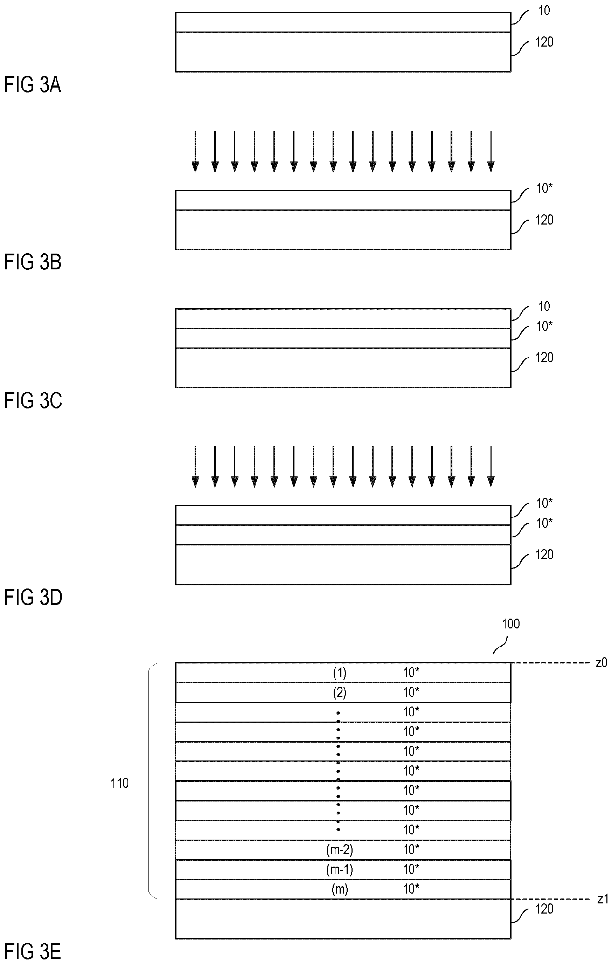

Figures 3A to 3E schematically illustrate one example of a semiconductor body 100 of the type shown in Figure 1 during (after) different process steps in accordance with a method of the type illustrated in Figure 2. Referring to Figures 3A to 3E, the method includes forming a plurality of semiconductor layers 10 one above the other on the carrier 120 and implanting dopant atoms of the first doping type and/or dopant atoms of the second doping type into each of the semiconductor layers 10, to obtain a respective implanted semiconductor layer 10*, before forming a next one of the semiconductor layers 10.

Figure 3A illustrates the layer stack after forming a first one 10 of the plurality of semiconductor layers on the carrier 120. Figure 3B illustrates the arrangement shown in Figure 3A during an implantation process in which dopant atoms of the first doping type and/or dopant atoms of the second doping type are implanted into the semiconductor layer 10 to obtain a first implanted region and/or a second implanted region A semiconductor layer having first type and/or second type dopant atoms implanted therein is referred to as implanted semiconductor layer 10* in the following.

Figure 3C illustrates the arrangement illustrated in Figure 3B after forming a further semiconductor layer 10 on top of the implanted layer 10*. Referring to Figure 3D, dopant atoms of the first doping type and/or dopant atoms of the second doping type are implanted into the further semiconductor layer 10, resulting in a further implanted layer 10*.

The process sequence of forming a semiconductor layer 10 and implanting dopant atoms of the first doping type and/or the second doping type into the respective semiconductor layer 10 to obtain an implanted semiconductor layer 10* is repeated until the layer stack 100 includes a desired number of implanted semiconductor layers 10*. According to one example, this number of implanted semiconductor layers 10* is between 4 and 60, in particular between 10 and 50, for example.

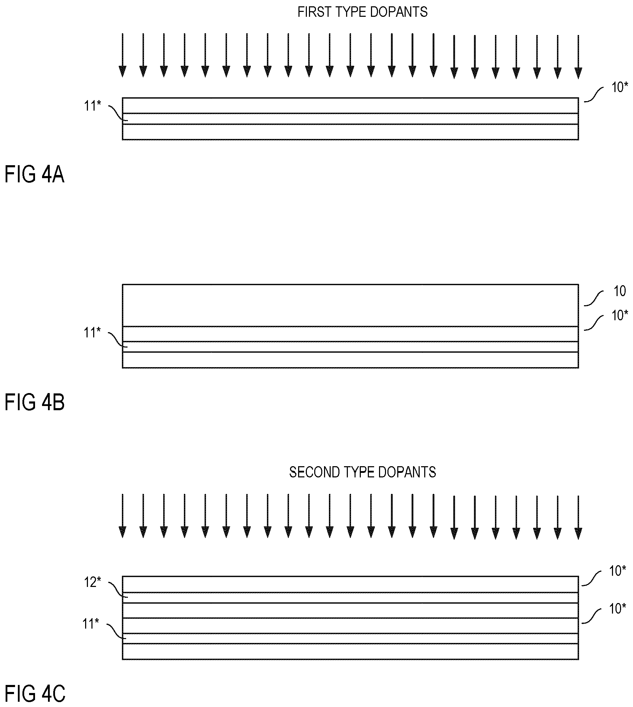

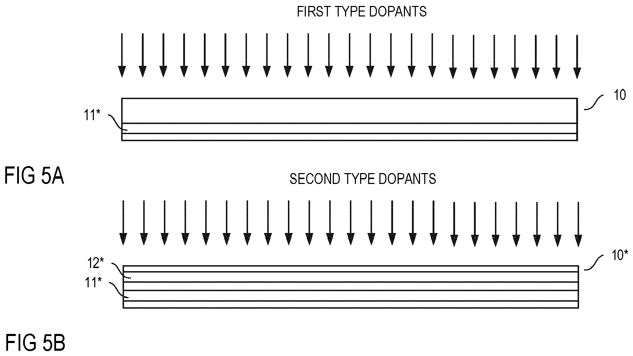

Referring to the above at least one of a first implanted region and a second implanted region is formed in each of the semiconductor layers 10 by implanting dopant atoms of the first doping type and/or implanting dopant atoms of the second doping type. Two different examples are explained below with reference to Figures 4A - 4C and 5A - 5B.

According to a first example illustrated in Figures 4A - 4C, only one implanted region is formed in each semiconductor layer 10. Figure 4A illustrates one semiconductor layer during an implantation process in which dopant atoms are implanted in order to form an implanted layer 10* with an implanted region. Just for the purpose of illustration, the implanted dopant atoms are first type dopant atoms so that the implanted region is a first implanted region 11*.

Referring to Figures 4B - 4C a further semiconductor layer 10 is formed on top of the implanted layer 10*, and dopant atoms are implanted into the further semiconductor layer to form a further implanted layer 10* with a further implanted region. These dopant atoms are second type dopant atoms, so that the further implanted region is a second implanted region 12*.

Forming only one implanted region in each semiconductor layer 10 results in a layer stack 110 in which first and second implanted regions are arranged alternatingly and in which the number of implanted regions 11*, 12* equals the number of implanted layers 10* in the layer stack.

According to a second example illustrated in Figures 5A - 5B, two implanted regions, a first implanted region 11* and a second implanted region 12*, are formed in each semiconductor layer 10 of the layer stack 110, wherein only one of these layers is illustrated in Figures 5A - 5B. Figure 5A, and Figure 5B illustrates the semiconductor layer 10 in a first implantation process in which second type dopant atoms are implanted to form a second implanted region 12*. Of course, the order in which the first and second implanted regions 11*, 12* are formed can be changed.

Referring to Figure 5B, the first and second implanted regions 11*, 12* are formed at different vertical positions of the semiconductor layer 10. More specifically, implantation energies in the first and second implantation process are selected such that an end-of-range in the first implantation process is at a vertical position of the semiconductor layer that is different from a vertical position of an end-of-range in the second implantation process.

Forming two implanted regions in each semiconductor layer 10 results in a layer stack 110 in which the number of implanted regions 11*, 12* is twice the number of implanted layers 10* in the layer stack 110. The two implanted regions 11*, 12* are formed in such a way in each semiconductor layer 10 that in the layers stack 110* the first and second implanted regions 11*, 12* are arranged alternatingly. In Figure 3, not the first and second implanted regions 11*, 12* inside the layer stack 110 are not shown.

The method is not limited to form one or two implanted regions in one semiconductor layer 10. It is also possible to form four, six or eight implanted regions in each semiconductor layer such that first and second implanted regions are arranged alternatingly at different vertical positions.

Referring to Figure 3, for the purpose of explanation it is assumed that each of the implanted layers 10* in the layer stack 110 has a respective order number, wherein the uppermost one of the implanted layers 10* has the lowest order number 1 and the lowermost one of the implanted layers 10* has the highest order number m, wherein m denotes the overall number of implanted layers in the layer stack 100. The uppermost implanted layer is that one of the implanted layers 10* that forms the upper vertical end z0 of the layer stack 111, and the lowermost implanted layer is that one of the implanted layers 10* that forms the lower vertical end z1 of the layer stack 110. The order numbers of the implanted layers are indicated in brackets in Figure 3.

Referring to the above, each of the implanted semiconductor layers 10* includes at least one of a first implanted region 11* and a second implanted region 12* such that first implanted regions 11* and second implanted regions 12* are arranged alternatingly in the layer stack 110.

Annealing the layer stack 110 after forming the implanted semiconductor layers 10* activates the implanted dopant atoms and results in the layer stack 100 of the type shown in Figure 1 that includes first semiconductor regions 11 resulting from the first implanted regions 11* and second semiconductor regions 12 resulting from the second implanted regions 12*, wherein the first and second regions 11, 12 are arranged alternatingly in the layer stack 110.

Just for the purpose of illustration, in the example shown in Figure 1, the lowermost region of the layer stack 110 is a second semiconductor region 12 and the uppermost region of the layer stack 110 is a first semiconductor region 11. According to another example (not shown) the lowermost region of the layer stack 110 is a first semiconductor region 11 and the uppermost region of the layer stack 110 is a second semiconductor region.

According to one example, forming each of the plurality of semiconductor layers 10 includes a respective epitaxial growth process before the dopant atoms are implanted. A manufacturing process of the type illustrated in Figures 3A to 3D, in which a plurality of semiconductor layers 10 are epitaxially grown and in which dopant atoms are implanted into each of the semiconductor layers 10 before forming a next one of the semiconductor layers 10 may be referred to as multi-epi-multi-implant (MEMI) process.

The epitaxial growth process includes depositing semiconductor material from a precursor under high temperatures. For depositing a monocrystalline silicon layer, for example, TCS (trichlorosilane) gas or DCS (dichlorosilane) may be used as the precursor. The temperature in the epitaxial growth process is higher than 1100°C, for example.

According to one example, the semiconductor layers 10 are formed as intrinsic layers, which are semiconductor layers that do not include an intended doping. The doping concentration of an intrinsic layer is less than $1E14$ cm$^{-3}$, for example. When forming the semiconductor layers 10 as intrinsic layers, the only intended doping of the individual first and second semiconductor regions 11, 12 in the finished semiconductor body 100 after the annealing process results from the implantation processes in which dopant atoms are implanted into the individual semiconductor layers 10. According to another example, the semiconductor layers 10 are formed to have a low basic doping of the first or second doping type. The dopants may be introduced in the epitaxial growth process and the doping concentration is between $1E14$ cm$^{-3}$ and $1E15$ cm$^{-3}$, for example.

Referring to the above, implanting the dopant atoms into a respective one of the semiconductor layers 10 may include forming only one implanted region that includes dopant atoms of only one doping type or may include forming two or more different implanted regions such that first and second implanted regions 11*, 12* are arranged alternatingly. Forming each implanted region may include only one implantation process using one implantation energy. Alternatively, two or more implantation processes using different implantation energies are used to implant the dopant atoms into the respective semiconductor layer 10 to form one implanted region 11* or 12*. According to one example, the at least one implantation energy is selected such that an end-of-range of the implantation process is within the respective semiconductor layer 10, so that dopant atoms are not implanted through the respective semiconductor layer 10 into one or more other semiconductor layers.

According to one example, the implantation process for forming each of the implanted regions 11*, 12* is a blanket process. That is, dopant atoms are implanted into the entire surface of the respective semiconductor layer 10.

Referring to the above, each of the implanted semiconductor layers 10* has a respective thickness, which is the dimension of the implanted semiconductor layer 10* in the vertical direction z. This thickness can be adjusted by suitably adjusting the process parameters in the epitaxial growth process used to form the respective implanted layer 10*. These process parameters include the duration of the respective growth process and a growth rate.

Furthermore, each of the implanted semiconductor layers 10* has a dopant dose D, which is given by the number of dopant atoms per area unit implanted into the respective layer 10* when forming the at least one implanted region.. When only one implanted region is formed in one semiconductor layer 10, the implantation dose D of the semiconductor layer 10 is the implantation dose implanted into the semiconductor layer for forming the implanted region. When a first and a second implanted region 11*, 12* are formed in one semiconductor layer 10, the implantation dose of the semiconductor layer 10 is given by an implantation dose D11 implanted into the semiconductor layer 10 to form the first implanted region 11* plus an implantation dose D12 implanted into the semiconductor layer 10 to form the second implanted region 12*, D=D11+D12. According to one example, these implantation doses D11, D12 are at least approximately equal.

Referring to the above, the layer stack with the plurality of implanted semiconductor layers 10* is formed such that the thickness specific dopant dose TD increases towards the lower vertical end z1 of the layer stack. This is explained in greater detail herein further below.

Referring to the above, each of the individual semiconductor layers 10 is formed using a respective epitaxial growth process in which semiconductor material is deposited in a high temperature ambient. The high temperature in a respective one of the epitaxial growth processes may cause a diffusion of those dopant atoms that are included in implanted semiconductor layers 10* that have been formed by one or more previous epitaxial growth processes. Basically, the more often an implanted layer 10* is subject to the high temperatures in an epitaxial growth process, the more the implanted dopant atoms included in this implanted layer 10* already diffuse before the final annealing process.

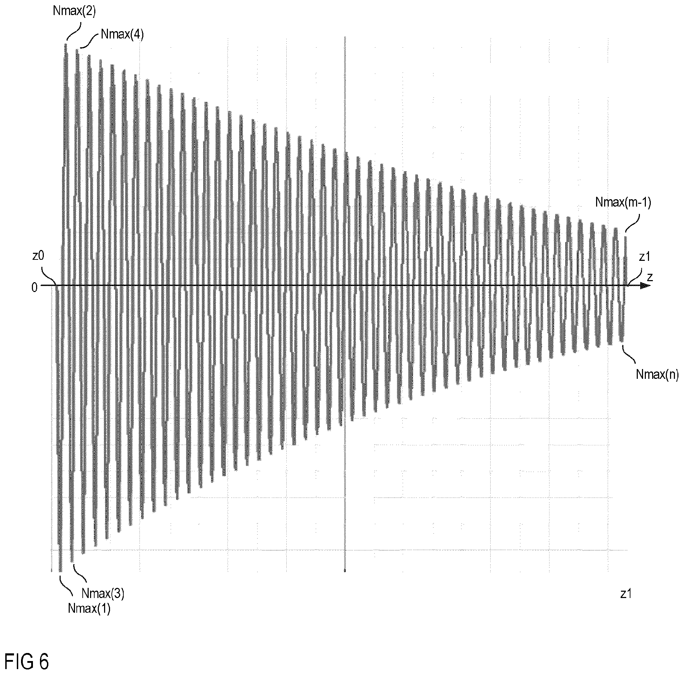

The dopant atoms may not only diffuse in the implanted layer 10* into which they were implanted, but may also diffuse into neighboring implanted layers 10* and may thereby affect the effective doping concentration in the neighboring implanted layers 10*. Basically, the more dopant atoms diffuse from a respective one of the implanted layers 10* into neighboring implanted layers, and the more dopant atoms diffuse from the neighboring implanted layers into the respective implanted layer 10*, the lower is the effective doping concentration of the semiconductor layer resulting from the respective implanted layer 10* after the annealing process. This is explained with reference to Figure 6.

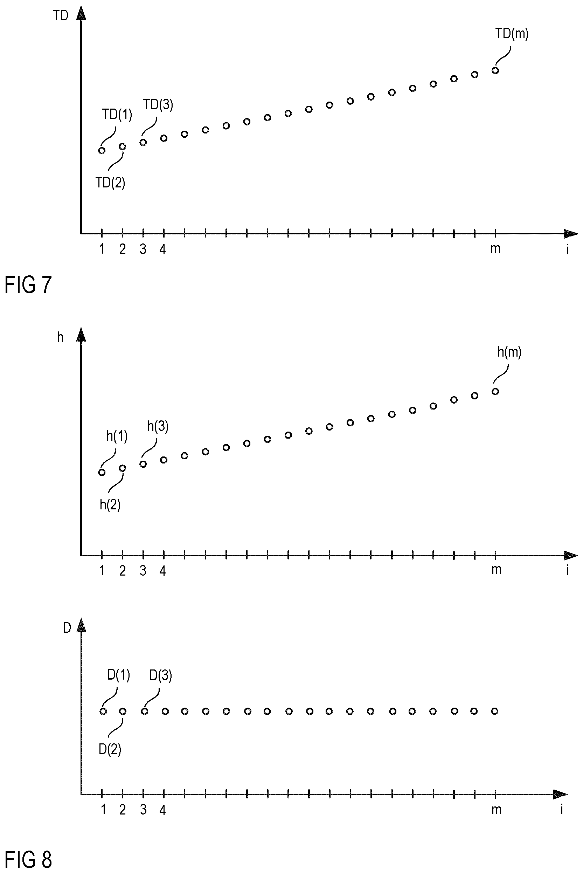

Figure 6 illustrates the effective doping concentration of a semiconductor body 100 of the type shown in Figure 1 and produced in accordance with a conventional MEMI process. Figure 7 illustrates the effective doping concentration N along a line extending in the vertical direction z through the layer stack 100 from the upper vertical end z0 to the lower vertical end z1. Due to the nature of the MEMI process, the effective doping concentration N is essentially the same at each point located at the same vertical position. The conventional process includes forming the individual semiconductor layers 10 with the same thickness and forming each implanted region with the same dopant dose, wherein at least one implanted region has been formed in each of the individual semiconductor layers 10.

The effective doping concentration illustrated in Figure 6 is in accordance with equation (1), so that positive effective doping concentrations represent doping concentrations in regions that have an effective n-type doping, and negative effective doping concentrations represent doping concentrations in regions that have an effective p-type doping. As can be seen from Figure 7, the effective doping concentration alternates between an effective n-type doping and an effective p-type doping. This is due to the fact that the layer stack, before the annealing process, includes first and second implanted regions 11*, 12* arranged alternatingly in the layer stack 110. A region in which the effective doping concentration is zero, represents a border between a first semiconductor region 11 and an adjacent second semiconductor region 12.

In Figure 6, Nmax(i) denotes the maximum effective doping concentration of a respective first or second semiconductor region 11, 12 having order number i. For example, Nmax(1) denotes the maximum effective doping concentration of the uppermost semiconductor region, and Nmax(n) denotes the maximum effective doping concentration of the lowermost semiconductor region. The overall number n of semiconductor regions in the semiconductor body 100 (a) equals the number m of layers 10 in the layer stack 110 when only one implanted region is formed in each layer 10 (n=m), and (b) is twice the number m of layers 10 in the layer stack 110 when two implanted regions are formed in each layer 10 (n=2m).

As can be seen from Figure 6, in a semiconductor body 100 formed in accordance with a conventional MEMI-process, the maximum effective doping concentration decreases towards the lower end z1 of the a semiconductor body 100. This is due to the fact that the earlier a semiconductor layer is formed in the process, the more often it is subject to high temperatures in an epitaxial growth process, and the more the implanted dopant atoms included in the respective layer are diffused before the final annealing process.

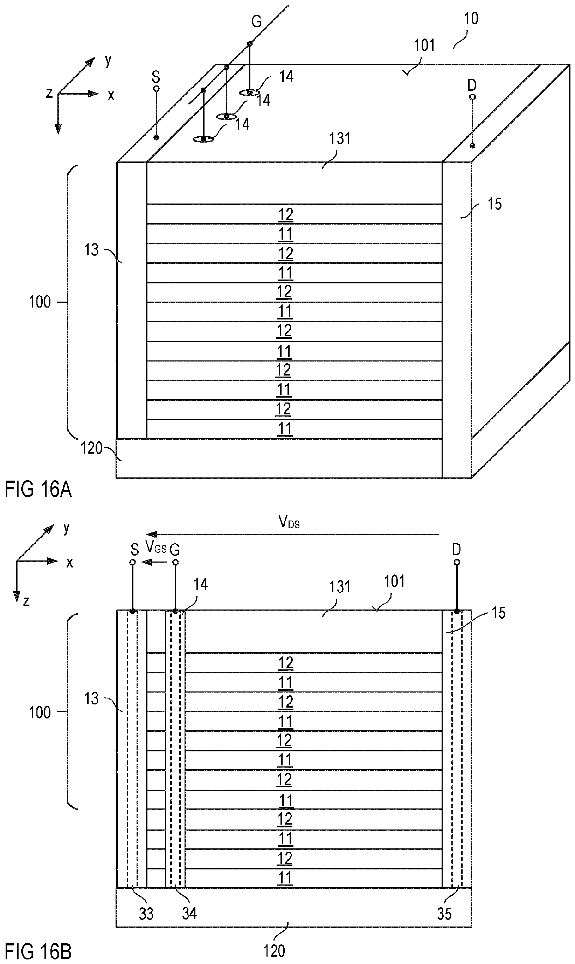

The lower the effective doping concentration of a respective first or second semiconductor region 11, 12, the higher the electrical resistance of the respective semiconductor region 11, 12. This situation is undesirable as will be explained in detail with reference to Figures 16A and 16B herein further below.

A decrease of the maximum effective doping concentration Nmax towards the lower end $z1$ of the layer stack 100 can be prevented or can at least be reduced by implementing the individual implanted layers 10* such that the thickness specific dopant dose TD in the layer stack 100 after forming the implanted regions 11*, 12* increases towards the lower vertical end $z1$ of the layer stack. Referring to the above, the thickness specific dopant dose TD is given by the thickness $d$ multiplied with the dopant dose D. Thus, increasing the thickness specific dopant dose TD towards the lower vertical end $z1$ includes forming the implanted layers such that at least one of the thickness $h$ and the dopant doses D in the sequence of neighboring implanted layers 10* increases towards the lower vertical end $z1$.

Basically, "to increase the thickness specific dopant dose TD towards the lower vertical end $z1$" includes that the layer stack 110 includes at least two implanted layers 10* that have different thickness specific dopant doses TD, wherein from the at least two implanted layers the one with the lower thickness specific dopant dose TD is arranged closer to the lower vertical end $z1$ than the one with the higher thickness specific dopant dose TD. There are various ways to increase the thickness specific dopant dose TD in the layer stack 100 towards the lower vertical end, some examples are explained in the following.

The examples explained in the following, schematically show graphs of the thickness specific dopant dose TD, the thickness $h$, or the dopant dose D of implanted layers 10* of a layer stack 110 of the type shown in Figure 3E. In these graphs, the individual implanted layers 10* are represented by their order number. As explained above, order number 1 represents the uppermost implanted layer in the layer stack 110, which is the layer forming the upper vertical end $z0$ of the layer stack 100, and order number $m$ represents the lowermost implanted layer in the layer stack 110, which is the layer forming the lower vertical end $z1$ of the layer stack 100, wherein $m$ is an integer that equals the overall number of implanted layers 10* in the layer stack 100.

Referring to the above, the dopant dose D of each implanted layer 10* represents the overall dopant dose of the implanted regions formed in the respective implanted layer 10*. In the event that a first implanted region 11* and a second implanted region 12* is formed in an implanted layer 10* the first dopant dose D11 of the first implanted region 11* may at least approximately equal the second dopant dose D12 of the second implanted region 12*. According to one example, "at least approximately equal" includes that each of the first and second dopant doses D11, D12 deviates less than 5%, less than 3%, or less than 1% from an average of these first and second dopant doses D11, D12.

Figure 7 illustrates one example in which the thickness specific dopant dose TD monotonically increases in the layers stack 100 between the upper vertical end $z0$ and the lower vertical end $z1$. To "monotonically increase" includes that thickness specific dopant doses TD of the plurality of implanted layers 10* are mutually different and each implanted layer 10* has a higher thickness specific dopant dose TD than the implanted layer 10* adjoining in the direction of the upper vertical end $z0$.

Figure 8 illustrates on example of how a thickness specific dopant dose profile of the type shown in Figure 7 can be achieved. In the example shown in Figure the dopant doses D(1) - D(m) implanted into the individual implanted layers 10* are essentially the same. According to one example, "essentially the same" includes that the dopant dose of each implanted layers 10* deviates less than 5%, less than 3%, or even less than 1% from an average of the dopant doses of the plurality of implanted layers 10*. According to one example, a first implanted region 11* and a second implanted region 12* is formed in each implanted layer 10*. According to one example, the first and second implanted regions 11*, 12* in each implanted layer 10* have essentially the same dopant dose. According to one example, the dopant dose of each of the first and second implanted layers 11*, 12* is selected from between 5E11cm$^{-2}$ and 5E13 cm$^{-2}$, in particular between 1E12 cm$^{-2}$ and 1E13 cm$^{-2}$, so that the dopant dose in each implanted layer 10* is between 1E12cm$^{-2}$ (=2*5E11cm$^{-2}$) and 1E14 cm$^{-2}$ (=2*5E13cm$^{-2}$).

Furthermore, in the example shown in Figure 8, the thickness h(1) - h(m) of the implanted layers 10* increases towards the lower vertical end $z1$, so that the uppermost implanted layer 10* has the lowest thickness h(1) and the lowermost implanted layer 10* has the highest thickness h(m). According to one example, the thickness increases linearly, so that the thickness h(i) of an arbitrary implanted layer, wherein $i$ is selected from between 1 and $m$ is given by

$$h(i) = h(1) + (i - 1) \cdot \Delta h \qquad (3),$$

wherein h(1) denotes the thickness of the uppermost layer and $\Delta h$ is the difference in layer thickness between adjacent implanted layers. According to one example, the lowest thickness h(1) is selected from between 1 micrometer ($\mu$m) and 4 micrometers, in particular from between 2 micrometers and 3 micrometers. According to one example, $\Delta h$ is selected from between 0.01 micrometers and 0.04 micrometers, in particular from between 0.02 micrometers and 0.03 micrometers. According to another example, $\Delta h$ is selected from between 0.5% and 4% of the minimum layer thickness (h1), in particular from between 1% and 3% of the minimum layer thickness h(1).

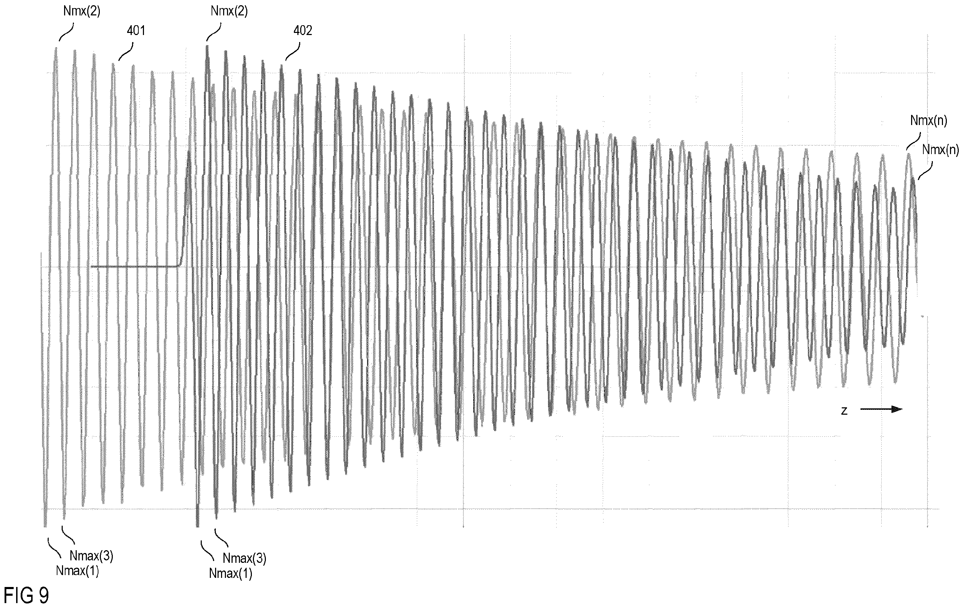

In Figure 9, curve 402 illustrates the effective doping concentration of a layer stack 100 produced in accordance with Figure 8 after the annealing process, and curve 401 illustrates the effective doping concentration of a layer stack 100 produced in accordance with a conventional process after the annealing process. According to one example, both layer stacks are produced in such a way that a first implanted region 11* and a second implanted region 12* is formed in each implanted layer 10*, so that the number n of doped regions 11, 12 in the finished semiconductor body 100 is twice the number m of implanted layers 10*.

Curve 401 equals the curve illustrated in Figure 6. In the conventional layer stack, the thickness of each implanted layer essentially equals the minimum thickness h(1) of the layer stack having a thickness profile as illustrated in Figure 8. Due to the increasing layer thickness, the layer stack with a thickness profile according to Figure 8 has a greater overall thickness than the conventional layer stack. If, for example, both layer stacks include m=40 implanted layers, the minimum thickness h(1)=2$\mu$m and $\Delta$h=0.02$\mu$m then the thickness of the conventional layer stack is 80 $\mu$m (=40*2$\mu$m) and the thickness of the layer stack having a thickness profile according to Figure 8 is about 96 $\mu$m. The thickness h(m) of the implanted layer 10* having the highest thickness is 2.8 $\mu$m.

A layer stack in which the thickness of the individual implanted players increases towards the lower vertical end z1 is referred to as layer stack with a graded thickness profile in the following. As can be seen from Figure 9, in a layer stack with a graded thickness profile, after the annealing process, there is still a decrease of the effective doping concentration in the individual layers towards the lower vertical end z1. However, this decrease is less than in a conventional layer stack after the annealing profile. This is beneficial in view of an on-resistance of a superjunction semiconductor device formed based on such layer stack. This is explained in detail herein further below.

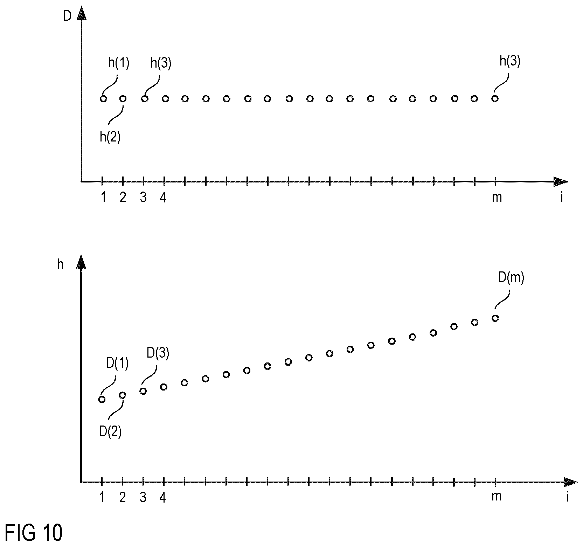

Figure 10 illustrates another way to obtain an increasing thickness specific dopant dose profile of the type shown in Figure 7, wherein the dopant dose profile and the thickness profile are illustrated in Figure 10. In the example shown in Figure 10, the individual implanted layers are formed to have essentially the same thickness, that is, the thicknesses h(1) - h(m) of the individual implanted layers are essentially the same. According to one example, the thickness is selected from between 1 micrometer and 4 micrometers, in particular from between 2 micrometers and 3 micrometers. In order to obtain thickness specific dopant dose profile in which the thickness specific dopant doses increase towards the lower vertical end z1, the implanted layers 10* are formed such that the dopant doses D increases towards the lower vertical end z1. In the example shown in Figure 10, the dopant dose D increases monotonically, that is, the implanted layers 10* have different dopant doses and the closer a respective implanted layer 10* is to the lower vertical end z1, the higher the dopant dose D. The dopant dose may increase linearly, so that the dopant dose D(i) of an arbitrary one of an implanted layer 10* is given by

$$D(i) = D(1) + \Delta D \qquad (4)$$

wherein D(1) denotes the dopant dose of the uppermost layer and $\Delta$D is the difference in the dopant dose between adjacent implanted layers. The lowest dopant dose D(1) is selected from between 1E12 cm$^{-2}$ and 1E14 cm$^{-2}$, in particular from between 2E12 cm$^{-2}$ and 2E13 cm$^{-2}$, for example. According to one example, a first implanted region 11* and a second implanted region 12* is formed in each implanted layer 10*. In this case, the dopant dose of each of the first implanted region 11* and the second implanted region 12* is 50% of the overall dose in each implanted layer 10*, that is, between 5E11 cm$^{-2}$ and 5E13 cm$^{-2}$, in particular between 1E12 cm$^{-2}$ and 1E13 cm$^{-2}$, for example.

According to another example, the dopant dose increases exponentially, so that the dopant dose D(i) of an arbitrary one of the implanted layers 10* is given by

$$D(i) = D(1) \cdot p^i \qquad (5)$$

wherein D(1) is the dopant dose of the uppermost implanted layer and p is a constant. According to one example, p is selected from between 1.01 and 1.1, in particular from between 1.02 and 1.05.

A layer stack 100 in which the dopant dose increases towards the lower vertical end z1 may be referred to as layer stack with a graded dopant dose profile.

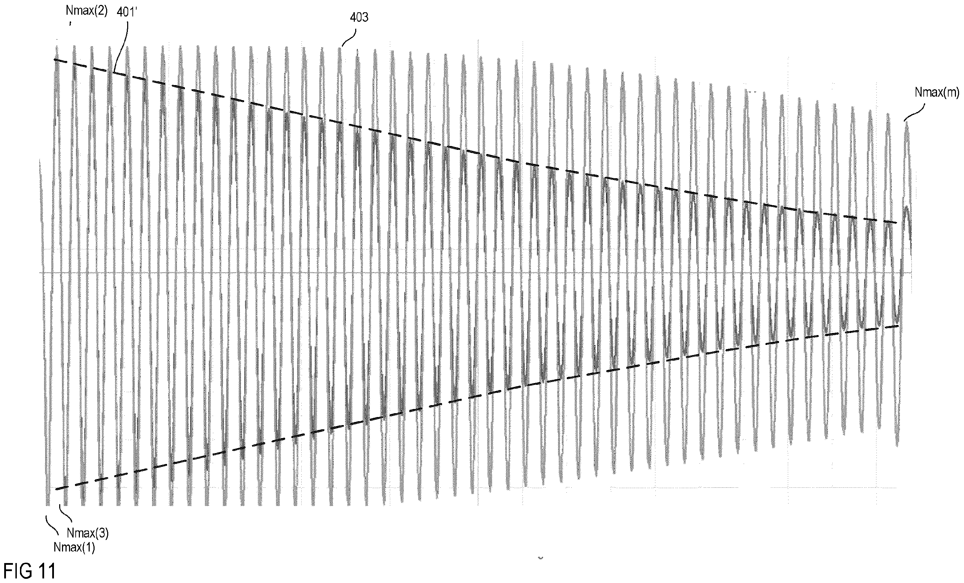

In Figure 11, curve 403 illustrates the effective doping dose of a layer stack, after the annealing process, having a thickness profile and a dopant dose profile as illustrated in Figure 10. Curve 401' illustrates the envelope of the curve representing the effective doping concentration in a layer stack formed in accordance with a conventional method after the annealing process. As can be seen from Figure 11, there may still be a decrease of the effective doping dose towards the lower vertical end z1. This decrease, however, is significantly lower than the decrease in a layer stack formed in accordance with the conventional method.

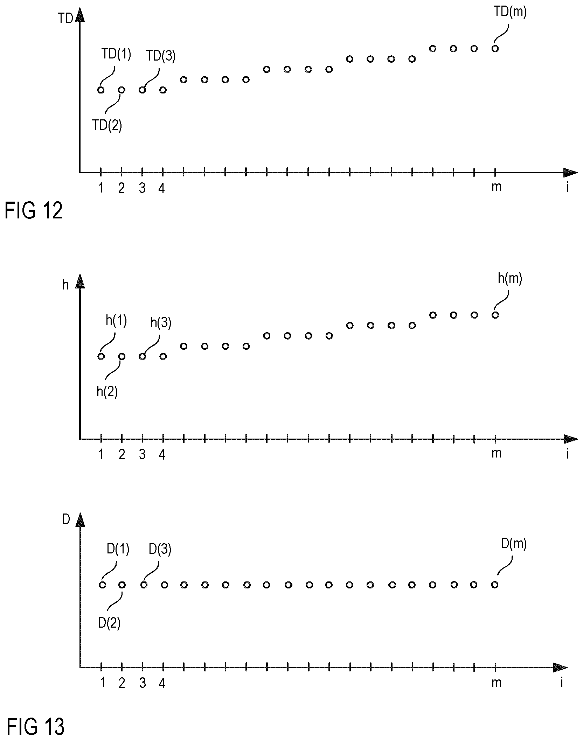

Forming the layer stack 100 such that the thickness specific dopant dose TD monotonically increases towards the lower vertical end z1, as illustrated in Figure 7, is only an example. According to another example illustrated in Figure 12, two or more neighboring implanted layers 10* have the same dopant dose and there are at least two groups of neighboring implanted layers that have different dopant doses, wherein the closer a respective group is located to the lower vertical end z1, the higher the dopant dose TD of the implanted layers in the group. The individual groups of neighboring implanted layers may have the same number of implanted layers or may have different numbers of implanted layers. According to one example, the number of implanted layers included in one group decreases towards the lower vertical end z1, that is, the closer a group is located to the lower vertical end z1, the less implanted layers are included in the group. Just for the purpose of illustration, in the example shown in Figure 12, the groups of neighboring layers with the same dopant dose have the same number of implanted layers.

Figure 13 illustrates a first example of a thickness profile and a dopant dose profile that result in a thickness specific dopant dose profile of the type shown in Figure 12. In this example the same dopant dose is implanted into the individual layers, so that the dopant doses D(1) - D(m)) of the individual implanted layers 10* are essentially the same. Furthermore, the individual implanted layers 10* have different thicknesses, wherein the thickness increases towards the lower vertical end and wherein the implanted layers in each group that have the same thickness specific dopant dose TD have the same thickness. Furthermore

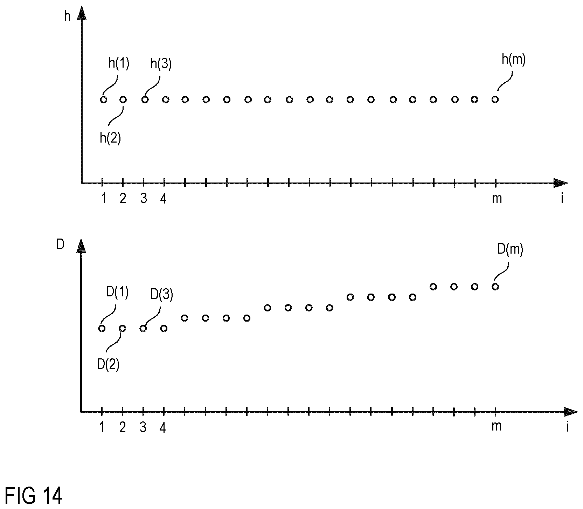

According to another example illustrated in Figure 14 a thickness specific dopant dose profile of the type shown in Figure 12 can be obtained by implementing the individual implanted layers 10* with the same thickness, so that the thicknesses h(1)-h(m) of the individual implanted layers 10* are essentially the same, and by varying the dopant dose D such that neighboring implanted layers of one group with the same thickness specific dopant dose have the same dopant dose D. The closer a respective group is located to the lower vertical end z1, the higher the dopant dose of the implanted layers included in the group.

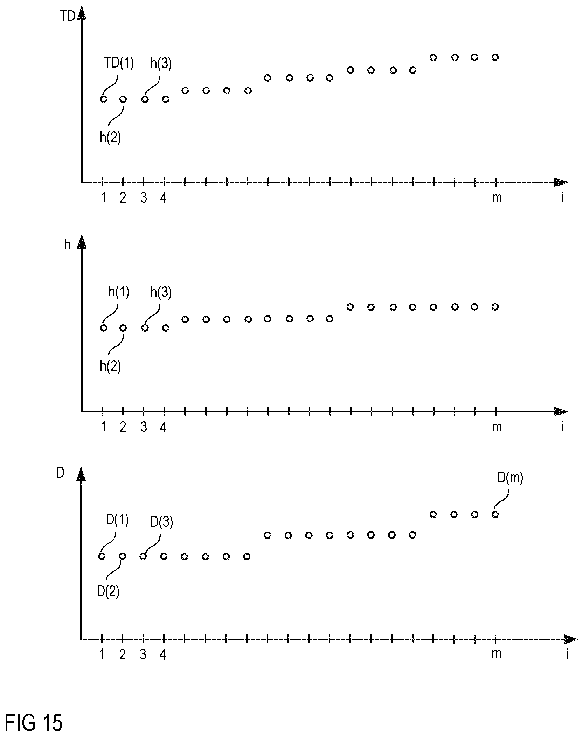

Referring to the above, the thickness specific dopant dose TD can be varied either by varying the thickness or by varying the dopant dose. In the examples explained before, one of these parameters (thickness or dopant dose) is the same throughout the layer stack, while the other parameter varies. This, however, is only an example. It is also possible to implement the layer stack such that two or more implanted layers have different thicknesses and two or more implanted layers have different dopant doses. One example for implementing the layer stack 100 in this way is illustrated in Figure 15. Just for the purpose of illustration, in this example, there are two or more groups each including two or more implanted layers, wherein the implanted layers included in each group have the same thickness specific dopant dose D, wherein the closer a respective group is to the lower vertical end z1, the higher the thickness specific dopant dose. In the example illustrated in Figure 15, both the thickness h and the dopant dose D varies. More specifically, both the thickness h and the dopant dose D increases towards the lower vertical end z1. The increase of the thickness h in this example includes that several neighboring implanted layers have the same thickness and increasing the dopant dose D towards the lower vertical end z1 includes that two or more implanted layers have the same dopant dose. This, however, is only an example. According to another example, the thickness specific dopant dose monotonically increases towards the lower vertical end z1, wherein this is obtained by monotonically increasing the thickness h towards the lower vertical end z1 and monotonically increasing the dopant dose D towards the lower vertical end z1.

Figures 16A - 16B show a perspective sectional view (Figure 16A) and a vertical cross sectional view (Figure 16B) of a lateral superjunction transistor device 10. The transistor device 10 has been formed based on a layer stack 100 of the type explained with reference to Figure 1 that has been produced in accordance with the method of the type illustrated in Figure 2. The layer stack shown in Figure 1 includes first and second semiconductor regions 11, 12. The transistor device may be formed based on such layer stack. Alternatively, as illustrated in Figures 14 and 16B, the layer stack may additionally include a third semiconductor region (layer) 131 as an uppermost layer of the layer stack. This third semiconductor layer 131 is a layer of the second doping type, for example. The third semiconductor layer 131 is an epitaxial layer and has a dopant dose that is lower than the dopant dose of each of the second semiconductor layers, for example.

Referring to Figures 16A and 16B, each of a source region 13 and a drain region 15 adjoins each of the plurality of first semiconductor regions 11, wherein the drain region 15 is located spaced apart from the source region 13 in a first lateral direction x of the layer stack 100. The first lateral direction x is perpendicular to the vertical direction z and parallel to the first surface 101. Further, each of a plurality of gate regions 14 (a) adjoins at least one of the plurality of second semiconductor regions 12, (b) is arranged between the source region 13 and the drain region 15, and (c) is spaced apart from the source region 13 and the first drain region 15.

According to one example, the overall number of first semiconductor regions 11 in the layer stack 100 equals the overall number of second semiconductor regions 12. In the example shown in Figures 16A and 16B, an uppermost one of the first and second semiconductor regions 11, 12 is a second semiconductor region 12 and a lowermost one is a first semiconductor region 11. However, implementing the uppermost layer as a second semiconductor region 12 and the lowermost layer as a first semiconductor region 11 is only an example. According to another example (not shown) the uppermost layer is a first semiconductor region 11 and the lowermost layer is a second semiconductor region 12.

Just for the purpose of illustration, in the example shown in Figures 16A - 16B, the layer stack 100 with the first and second semiconductor regions 11, 12 includes four six semiconductor regions 11 and six second semiconductor regions 12, so that the layer stack includes twelve layers. This, however, is only an example. According to one example, the overall number of complementary first and second regions 11, 12 in the layer stack 100 is between 4 and 60, between 4 and 30, or between 6 and 20.

In the example illustrated in Figures 16A - 16B, each of the source region 13 and the drain region 15 extends in the vertical direction z in the semiconductor body 100 such that each of the source region 13 and the drain region 15 adjoins each of the first regions 11 (and the second regions 12). Further, in this example, the gate regions 14 extend in the vertical direction z in the semiconductor body 100 so that each of the plurality of gate regions 14 adjoins each of the second semiconductor regions 12. The gate regions 14 are spaced apart from each other in the second lateral direction y. This second lateral direction y is different from the first lateral direction x and may be perpendicular to the first lateral direction x.

The lateral superjunction transistor device 10 illustrated in Figures 16A - 16B is a depletion device, more specifically, a JFET (Junction Field-Effect Transistor). In this transistor device 10, each of the source region 13 and the drain region 15 is a region of the first doping type and each of the gate regions 14 is a region of the second doping type. Further, in the region between the source region 14 and the drain region 15, the first semiconductor regions 11 form drift regions and the second semiconductor regions 12 form compensation regions of the transistor device. Thus, in the context of the transistor device shown in Figures 16A and 16B, the first semiconductor regions 11 are also referred to as drift regions and the second semiconductor regions 12 are also referred to as compensation regions. The function of these drift and compensation regions 11, 12 is explained herein further below.

The transistor device can be implemented as an n-type transistor device or as a p-type transistor device, wherein the specific type is defined by the type of the first doping type. The first transistor device 10 is an n-type JFET when the first doping type is an n-type and the second doping type is a p-type. Equivalently, the first transistor device 10 is a p-type JFET when the first doping type is a p-type and the second doping type is an n-type.

Referring to Figures 16A and 16B, the source region 13 is connected to a source node S, the gate regions 14 are connected to a gate node G, and the drain region 15 is connected to a drain node D. The source node S, the gate node G, and the drain node D are only schematically illustrated in Figures 16A and 16B. These device nodes S, G, D may include metallizations (not shown) on top of the layer stack 100 or on the trench sidewalls. Optionally, as illustrated in dashed lines in Figure 16B, a first electrode 33 may be embedded in the source region 13, second electrodes 34 may be embedded in the gate regions 14, and a third electrode 35 may be embedded in the drain region 35. The first electrode 33 is connected to the source node S, the second electrodes 34 are connected to the gate node G, and the third electrode 35 is connected to the drain node D. Each of these electrodes 34, 35, 33 includes an electrically conducting material. Examples of such electrically conducting material include, but are not restricted to: a metal such as copper (Cu), aluminum (Al), tantalum (Ta), titanium (Ti), cobalt (Co), nickel (Ni) or tungsten (W); a highly doped polycrystalline semiconductor material such as polysilicon; or a metal silicide, such as tungsten silicide (WSi), titanium silicide (TiSi), Cobalt silicide (CoSi), or nickel silicide (NiSi).

The function of the lateral superjunction transistor device shown in Figures 16A - 16B is explained below. Just for the purpose of explanation, it is assumed that the transistor device is an n-type JFET. In this case, the transistor device 10 is in an on-state (switched on state) when a voltage level of a gate-source voltage $V_{GS}$ received between the gate node G and the source node S, is higher than a predefined threshold level $V_{th}$. That is, the transistor device 10 is in the on-state, when $V_{GS} > V_{th}$, where the threshold voltage $V_{th}$ is negative ($V_{th1} < 0$) in an n-type JFET. In the on-state, a current can flow between the source region 13 and the drain region 15 via the first regions (drift regions) 11 when a suitable voltage is applied between the drain node D and the source node S.

When the transistor device 10 is in the on-state and the gate-source voltage $V_{GS}$ decreases p-n junctions between the first source region 13 and the compensation regions 12 and between the gate regions 14 and the drift regions 11 are becoming reverse biased. Furthermore, p-n junctions between the drift regions 11 and the compensation regions 12 are becoming reverse biased. Reverse biasing those p-n junctions causes the drift regions 11 to be depleted of charge carriers. The transistor device 10 switches off as soon as sections of the drift regions 11 between the at least two gate regions 14 and/or between the gate regions 14 and the source region 13 have been completely been depleted of charge carriers. The threshold voltage $V_{th}$ is the voltage at which the transistor device 10 switches off.

The magnitude (the level) of the threshold voltage $V_{th}$ is dependent on several design parameters and can be adjusted by suitably designing these parameters. These design parameters include, for example, the (shortest) distance between two neighboring gate regions 14, a doping concentration of the drift regions 11, and a doping concentration of the compensation regions 12.

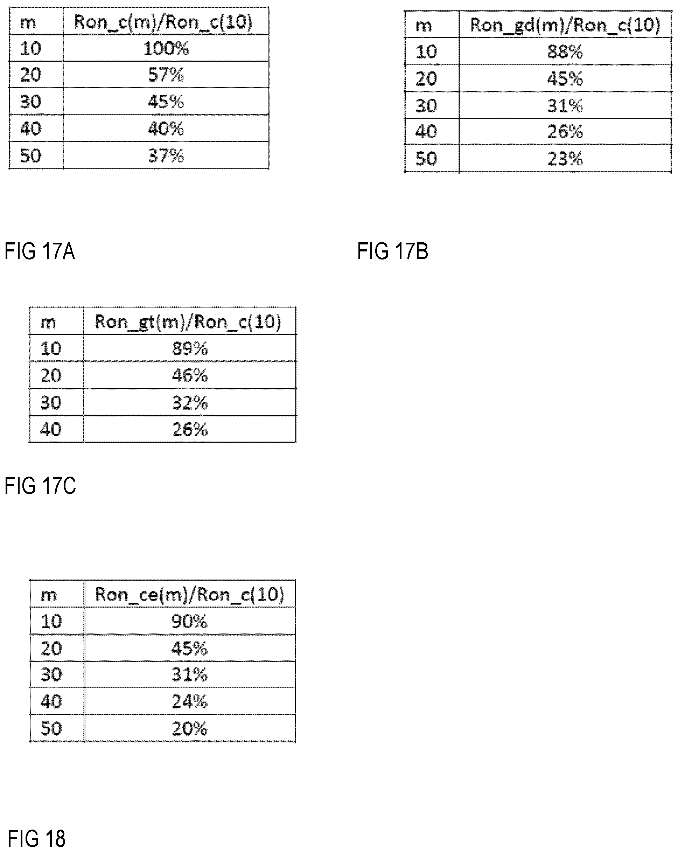

An on-resistance of the transistor device the electrical resistance of the transistor device between the drain node D and the source node S in the on-state of the transistor device. This on- resistance is essentially given by the electrical resistance of the drift regions 11 between the source region 13 and the drain region 15. The electrical resistance of each drift region is, inter alia, dependent on the effective doping concentration of the respective drift region, wherein the higher the effective doping concentration, the lower the resistance. The significant decrease of the effective doping concentration in a layer stack produced in accordance with a conventional MEMI process (see, Figure 7) has the effect that (i) the on-resistance of a transistor device formed in accordance with this method is significantly lower than possible, and (ii) increasing the number of semiconductor layers to beyond a certain number, such as 40 or 50, does not have a significant effect on the reduction of the on-resistance. This is illustrated in Figure 17A.

Figure 17A shows a table that illustrates the relationship between the on-resistances of transistor devices that have been formed based on a conventional layer stack having between 10 and 50 layers, wherein Ron_c(m) denotes the respective on-resistance and wherein m is 10, 20, 30, 40, or 50. The table shown in Figure 15 is based on simulations of a semiconductor body in which each of the layers has the same thickness of 2 micrometers, in which a first and a second implanted region has been formed in each implanted layer, and in which each implanted region has the same dopant dose of $3.5E12$ cm$^{-2}$ (resulting in an overall dopant dose of $7E12$ cm$^{-2}$ in each implanted layer). The on-resistance Ron_c(10) of the transistor device with 10 layers in the layer stack is used as a reference (100%), wherein Figure 17A illustrates the on-resistances of the transistor devices having more than 10 layers relative to the on-resistance Ron_c(10) of the transistor device having 10 layers.

Theoretically, if there were no diffusion effects due the epitaxial growth process, one would expect the on-resistance to linearly decrease with each pair including a first semiconductor region 11 and a second semiconductor region 12 being added to the layer stack. That is, for example, one would expect that the on-resistance Ron_c(50) of a transistor device having 50 layers is only 20% of the on-resistance Ron_c(10) of the transistor device having only 10 layers. In fact, however, the on-resistance Ron_c(50) of the transistor device having 50 layers is 37% of Ron_c(10) and, therefore, much higher than expected.

Referring to the above, in a layer stack formed with a graded dopant dose profile and/or a graded thickness profile, the reduction of the effective doping concentration towards the lower vertical end is significantly lower than in a conventional layer stack, resulting in a superjunction transistor device with a lower on-resistance. This is illustrated in Figures 17B and 17C.

Figure 17B illustrates the on-resistances of transistor devices that each have been formed based on a layer stack with a graded dopant dose. Each layer in this layer stack has the same thickness ($2\mu m$) as the layers in the conventional layer stack explained with reference to Figure 17A, and the dopant dose increases in accordance with equation (5), wherein the dopant dose D(1) of the uppermost layer is the same as the dopant dose in each layer of the conventional stack, and wherein p=0.023. In the table shown Figure 17B, the on-resistances Ron_gd(m) of the transistor devices are given relative to the on-resistance Ron_c(10) of the conventional transistor device having 10 layers.

As can be seen by comparing the tables in Figures 17A and Figure 17B, implementing the layer stack with a graded dopant dose helps to significantly reduce the on-resistance as compared to the conventional device. Even in a layer stack with only 10 layers a significant improvement can be detected. The on-resistance Ron_gd(50) of the transistor device having 50 layers is 23% of the on-resistance of the conventional transistor device with 10 layers. As compared to 37% that can be achieved in the conventional device this is a significant improvement.

Figure 17C illustrates the on-resistances of transistor devices that each have been formed based on a layer stack with a graded thickness. Each implanted region in each layer in this layer stack has the same dopant dose (e.g., $3.5E12$ cm$^{-2}$, resulting in an overall dopant dose of $7E12$ cm$^{-2}$ in each layer)) as the layers in the conventional layer stack explained with reference to Figure 17A, and the thickness increases linearly in accordance with equation (3), wherein the thickness h(1) of the uppermost layer is the same as the thickness of each layer in the conventional stack ($2\mu m$), and wherein $\Delta h=0.02\mu m$. In the table shown Figure 17C, the on-resistances Ron_gt(m) of the transistor devices are given relative to the on-resistance Ron_c(10) of the conventional transistor device having 10 layers.

As can be seen by comparing the tables in Figures 17A and Figure 17C, implementing the layer stack with a graded thickness helps to significantly reduce the on-resistance as compared to the conventional device. The on-resistance Ron_gt(40) of the transistor device having 50 layers is 26% of the on-resistance of the conventional transistor device with 10 layers. As compared to 37% that can be achieved in the conventional device this is a significant improvement.

It should be noted that a layer stack with a graded thickness and/or a graded dopant dose is not restricted to be used for implementing a transistor device as illustrated in Figures 16A - 16B but may be used for implementing other types of semiconductor device such as diodes as well. Based on the transistor device shown in Figures 16A - 16B a diode may be obtained by omitting the gate regions 14. In this case, the source region 13 forms an anode of the diode and the drain region 15 forms a cathode of the diode.

According to another example, forming the layer stack shown in Figure 3 includes forming the layers with the same thickness and the same dopant dose but modifying the epitaxial growth process in such a way that the temperature is too low to cause dopant atoms that have already been implanted to diffuse. An epitaxial growth process of this type may be referred to as "cold epitaxial growth process". According to one example, the temperature in this process is selected from between 800 °C and 900 °C. The downside of such low temperatures is that the growth rates are significantly lower than the growth rates in epitaxial growth processes using temperatures of more than 1000 °C or more than 1100 °C.

Figure 18 illustrates the on-resistances Ron_ce(m) of a transistor device including a layer stack that has been produced using a cold epitaxial growth process relative to the on-resistance Ron_c(10) of a conventional device with 10 layers. The thickness and the dopant dose of the individual layers in the stack formed based on the cold epitaxial growth process is the same as the thickness and the dopant dose of the individual layers in the layers stack of the conventional device. As can be seen by comparing Figures 17A and 16 forming the layer stack using a cold epitaxial growth process helps to significantly reduce the on-resistance as compared to the conventional device.

Although the present disclosure is not so limited, the following numbered examples demonstrate one or more aspects of the disclosure.

Example 1 - A method, including: forming a layer stack with a plurality of semiconductor layers each including at least one of a first implanted region including implanted dopant atoms of a first doping type and a second implanted region including implanted dopant atoms of a second doping type and each having a thickness specific dopant dose, which is given by a dopant dose of the respective semiconductor layer multiplied with a thickness of the respective semiconductor layer; and annealing the layer stack to activate the implanted dopant atoms, wherein forming the layer stack includes forming the plurality of semiconductor layers such that first implanted regions and second implanted regions are arranged alternatingly in the layer stack, and such that in the layer stack the thickness specific dopant dose increases towards a lower vertical end of the layer stack.

Example 2 - The method of example 1, wherein the plurality of semiconductor layers are formed such that each of the plurality of semiconductor layers has a different thickness specific dopant dose.

Example 3 - The method of example 1, wherein the plurality of semiconductor layers are formed such that the semiconductor layers of at least one group of two or more semiconductor layers have the same thickness specific dopant dose.

Example 4 - The method of any one of examples 1 to 3, wherein the plurality of semiconductor layers are formed such that each of the plurality of semiconductor layers has a different thickness.

Example 5 - The method of example 4, wherein the plurality of semiconductor layers are formed such that the thickness increases linearly towards the lower end.

Example 6 - The method of any one of examples 1 to 3, wherein the plurality of semiconductor layers are formed such that the semiconductor layers of at least one group of two or more semiconductor layers have the same thickness.

Example 7 - The method of any one of examples 1 to 3, wherein the plurality of semiconductor layers are formed such that each of the plurality of semiconductor layers has a different dopant dose.

Example 8 - The method of example 7, wherein the plurality of semiconductor layers are formed such that the dopant dose increases exponentially towards the lower end.

Example 9 - The method of any one of examples 1 to 3, wherein the plurality of semiconductor layers are formed such that the semiconductor layers of at least one group of two or more semiconductor layers have the same dopant dose.

Example 10 - The method of any one of the preceding examples, wherein the dopant dose is selected from between $1E12\ cm^{-2}$ and $1E14\ cm^{-2}$.

Example 11 - The method of any one of the preceding examples, wherein the thickness is selected from between 1.5 micrometers and 4 micrometers.

Example 12 - The method of any one of the preceding examples, wherein forming each of the plurality of semiconductor layers includes: epitaxially growing a semiconductor layer; and blanket implanting the dopant atoms into the semiconductor layer.

Example 13 - The method of example 12, wherein blanket implanting the dopant atoms includes implanting the dopant atoms in at least two implantation processes with different implantation energies.

Example 14 - The method of any one of examples 1 to 13, further including: forming a transistor device based on the layer stack, wherein forming the transistor devices includes forming a source region, a drain region, and a plurality of gate regions, wherein the drain region is spaced apart from the source region in a first lateral direction of the layer stack, and wherein the gate regions, in the first lateral direction, are located between the source region and the drain region.

Example 15 - The method of any one of examples 1 to 13, further including: forming a diode based on the layer stack, wherein forming the diode includes forming an anode region and a cathode region such that the cathode region is spaced apart from the anode region in a first lateral direction of the layer stack.

Example 16 - The method of any one of examples 1 to 15, wherein each implanted semiconductor layer only includes one of a first implanted region and a second implanted region.

Example 17 - The method of any one of examples 1 to 15, wherein each implanted semiconductor layer includes both a first implanted region and a second implanted region.

Example 18 - The method of example 17, wherein the first implanted region and the second implanted region in each implanted semiconductor layer at least approximately have the same dopant dose.

**Claims**

1. A method, comprising:

   forming a layer stack (100) with a plurality of semiconductor layers (10*) each comprising at least one of a first implanted region (11*) comprising implanted dopant atoms of a first doping type and a second implanted region (12*) comprising implanted dopant atoms of a second doping type and each having a thickness specific dopant dose (TD), which is given by a dopant dose (D) of the respective semiconductor layer (10*) multiplied with a thickness (h) of the respective semiconductor layer (10*); and
   annealing the layer stack (100) to activate the implanted dopant atoms,
   wherein forming the layer stack (100) comprises forming the plurality of semiconductor layers (10*)
   such that first implanted regions (11*) and second implanted regions (12*) are arranged alternatingly in the layer stack (100), and
   such that in the layer stack (100) the thickness specific dopant dose (TD) increases towards a lower vertical end (z1) of the layer stack (100).

2. The method of claim 1,
   wherein the plurality of semiconductor layers are formed such that each of the plurality of semiconductor layers has a different thickness specific dopant dose (TD).

3. The method of claim 1,
   wherein the plurality of semiconductor layers are formed such that the semiconductor layers of at least one group of two or more semiconductor layers (10*) have the same thickness specific dopant dose (TD).

4. The method of any one of claims 1 to 3, wherein the plurality of semiconductor layers are formed such that each of the plurality of semiconductor layers has a different thickness (h).

5. The method of claim 4, wherein the plurality of semiconductor layers are formed such that the thickness (d) increases linearly towards the lower end (z1).

6. The method of any one of claims 1 to 3,
   wherein the plurality of semiconductor layers are formed such that the semiconductor layers of at least one group of two or more semiconductor layers (10*) have the same thickness (h).

7. The method of any one of claims 1 to 3, wherein the plurality of semiconductor layers are formed such that each of the plurality of semiconductor layers has a different dopant dose (D).

8. The method of claim 7, wherein the plurality of semiconductor layers are formed such that the dopant dose increases exponentially towards the lower end (z1).

9. The method of any one of claims 1 to 3,
   wherein the plurality of semiconductor layers are formed such that the semiconductor layers of at least one group of two or more semiconductor layers (10*) have the same dopant dose (D).

10. The method of any one of the preceding claims,
wherein the dopant dose is selected from between 1E12 cm$^{-2}$ and 1E14 cm$^{-2}$.

11. The method of any one of the preceding claims,
wherein the thickness is selected from between 1.5 micrometers and 4 micrometers.

12. The method of any one of the preceding claims, wherein forming each of the plurality of semiconductor layers (10*) comprises:

epitaxially growing a semiconductor layer; and
blanket implanting the dopant atoms into the semiconductor layer.

13. The method of claim 12,
wherein blanket implanting the dopant atoms comprises implanting the dopant atoms in at least two implantation processes with different implantation energies.

14. The method of any one of claims 1 to 13, further comprising:

forming a transistor device (10) based on the layer stack (100),
wherein forming the transistor devices comprises forming a source region (13), a drain region (15), and a plurality of gate regions (14),
wherein the drain region (15) is spaced apart from the source region (13) in a first lateral direction (x) of the layer stack (100), and
wherein the gate regions (14), in the first lateral direction (x), are located between the source region (13) and the drain region (15).

15. The method of any one of claims 1 to 13, further comprising:

forming a diode based on the layer stack (100),
wherein forming the diode comprises forming an anode region and a cathode region such that the cathode region is spaced apart from the anode region in a first lateral direction of the layer stack.

FIG 1

FIG 2

FORMING A LAYER STACK WITH A PLURALITY OF SEMICONDUCTOR LAYERS EACH INCLUDING AT LEAST ONE OF A FIRST IMPLANTED REGION AND A SECOND IMPLANTED REGION AND EACH HAVING A THICKNESS SPECIFIC DOPANT DOSE, SUCH THAT THE FIRST IMPLANTED REGIONS AND THE SECOND IMPLANTED REGIONS ARE ARRANGED ALTERNATINGLY IN THE LAYER STACK , AND
SUCH THAT IN THE LAYER STACK THE THICKNESS SPECIFIC DOPANT DOSE INCREASES TOWARDS A LOWER VERTICAL END OF THE LAYER STACK. 301

ANNEALING THE LAYER STACK TO ACTIVATE THE IMPLANTED DOPANT ATOMS 302

FIG 3A

FIG 3B

FIG 3C

FIG 3D

FIG 3E

FIRST TYPE DOPANTS

FIG 4A

FIG 4B

SECOND TYPE DOPANTS

FIG 4C

FIRST TYPE DOPANTS

FIG 5A

SECOND TYPE DOPANTS

FIG 5B

FIG 6

FIG 7

FIG 8

EP 4 053 910 A1

Nmx(2)    Nmx(2)    402
          401

Nmx(n)
Nmx(n)

z →

Nmax(3)    Nmax(3)
Nmax(1)    Nmax(1)

FIG 9

FIG 10

FIG 11

FIG 12

FIG 13

FIG 14

FIG 15

FIG 16A

FIG 16B

| m | Ron_c(m)/Ron_c(10) |
|---|---|
| 10 | 100% |
| 20 | 57% |
| 30 | 45% |
| 40 | 40% |
| 50 | 37% |

| m | Ron_gd(m)/Ron_c(10) |
|---|---|
| 10 | 88% |
| 20 | 45% |
| 30 | 31% |
| 40 | 26% |
| 50 | 23% |

FIG 17A

FIG 17B

| m | Ron_gt(m)/Ron_c(10) |
|---|---|
| 10 | 89% |
| 20 | 46% |
| 30 | 32% |
| 40 | 26% |

FIG 17C

| m | Ron_ce(m)/Ron_c(10) |
|---|---|
| 10 | 90% |
| 20 | 45% |
| 30 | 31% |
| 40 | 24% |
| 50 | 20% |

FIG 18

Europäisches
Patentamt

European
Patent Office

Office européen
des brevets

# EUROPEAN SEARCH REPORT

**Application Number**

EP 21 16 0037

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/052196 A1 (KONINKL PHILIPS ELECTRONICS NV [NL]; LUDIKHUIZE ADRIANUS W [NL] ET AL.) 10 May 2007 (2007-05-10) * page 6, line 22 - page 11, line 9; figures 1-12 * ----- | 1-15 | INV. H01L29/06 H01L29/808 H01L29/10 H01L29/417 |

TECHNICAL FIELDS
SEARCHED      (IPC)

H01L

The present search report has been drawn up for all claims

| Place of search | Date of completion of the search | Examiner |
|---|---|---|
| Munich | 11 August 2021 | Götz, Andreas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 16 0037

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2021

| Patent document cited in search report | Publication date | Patent family member(s) | | Publication date |
|---|---|---|---|---|
| WO 2007052196 A1 | 10-05-2007 | CN | 101300679 A | 05-11-2008 |
| | | EP | 1946378 A1 | 23-07-2008 |
| | | JP | 2009515332 A | 09-04-2009 |
| | | US | 2008093641 A1 | 24-04-2008 |
| | | WO | 2007052196 A1 | 10-05-2007 |

EPO FORM P0459

For more details about this annex : see Official Journal of the European Patent Office, No. 12/82